Europäisches Patentamt

(19) European Patent Office

Office européen des brevets

(11) Publication number : **0 510 905 A1**

(12) **EUROPEAN PATENT APPLICATION**

(21) Application number : 92303530.7

(22) Date of filing : 21.04.92

(51) Int. Cl.⁵ : **H01L 23/495, H01L 23/31**

(30) Priority : **22.04.91 US 688806**

(43) Date of publication of application :
**28.10.92 Bulletin 92/44**

(84) Designated Contracting States :
**DE FR GB**

(71) Applicant : **MOTOROLA, INC.**
**1303 East Algonquin Road**
**Schaumburg, IL 60196 (US)**

(72) Inventor : **Berg, Howard M.**
**12017 N. 84th Street**
**Scottsdale, Arizona 85260 (US)**
Inventor : **Flowers, Dervin L.**
**6629 E. Monterosa**
**Scottsdale, Arizona 85251 (US)**
Inventor : **Lewis, Gary L.**
**9021 W. Williams Road**
**Preoria, Arizona 85382 (US)**

(74) Representative : **Ibbotson, Harold et al**
**MOTOROLA European Intellectual Property**
**Operations Jays Close Viables Ind. Estate**
**Basingstoke Hants RG22 4PD (GB)**

(54) **Semiconductor package which does not delaminate or crack.**

(57) A semiconductor package (20) which does not delaminate or crack is comprised of a leadframe (10) having a flag (12) with a central portion of the flag (12) removed and a semiconductor die (24) having a front-side (24a) and a back-side (24b), wherein the back-side (24b) is attached to the flag (12). A dielectric layer (26) is disposed on the back-side (24b) of the semiconductor die (24), wherein the dielectric layer (26) is of a thickness approximately greater than the thickness of a native oxide. A mold compound (22) encapsulates the semiconductor die (24) and a portion of the leadframe (10).

*FIG. 2*

EP 0 510 905 A1

## Background of the Invention

This invention relates, in general, to semiconductor packages, and more particularly to semiconductor packages which do not crack or delaminate when subject to thermal shock.

For certain applications, semiconductor dice are housed in a surface mount plastic package. This package is comprised of a semiconductor die bonded to a die pad, die paddle or flag of a leadframe. The semiconductor die and a portion of the leadframe are encapsulated by A mold compound. A problem with surface mount plastic packages is that they are prone to crack when the package is saturated with moisture and subjected to a thermal shock. These types of failures have been called "popcorn" failures due to the similarities of a popcorn kernel popping when subject to heat.

Surface mount plastic packages are usually subjected to a thermal shock during soldering to a printed circuit board. The popcorn problem normally begins with the delamination of the flag-mold compound and the die bond-flag interfaces in the package. The delamination causes the package to swell and eventually crack. Preventing this delamination precludes popcorn failures. Delamination may be prevented by improving the adhesion between the flag-mold compound interface and/or the die bond-flag interface. Thus, the key to preventing popcorn problems is to prevent delamination by improving the adhesion at all interfaces in the package.

Attempts to solve the popcorn problem have not rendered a suitable solution to date. These attempts include improvements to the mold compound, improvements to the leadframe coating and treatments, improvements in flag design features, and improvements in die attach materials. Because these attempts have not prevented delamination, the current solution is to prevent the package from being exposed to moisture. This includes storing the semiconductor packages in dry packaging with a desiccant. The semiconductor packages must be kept dry until mounting to a printed circuit board. Solving the popcorn problem would result in a major cost savings by eliminating popcorn failures. In addition, it would not be necessary to store the semiconductor packages in a dry environment.

## Summary of the Invention

Briefly stated, a semiconductor package is comprised of a leadframe having a flag with a central portion of the flag removed and a semiconductor die having a front-side and a back-side, and wherein the back-side is attached to the flag. A dielectric layer is disposed on the backside of the semiconductor die, wherein the dielectric layer is of a thickness approximately greater than the thickness of a native oxide. A mold compound encapsulates the semiconductor die and a portion of the leadframe.

## Brief Description of the Drawings

FIG. 1 illustrates a top view of a portion of a leadframe used in the present invention; and
FIG. 2 illustrates an enlarged, cross-sectional view of an embodiment of the present invention.

## Detailed Description of the Preferred Embodiment

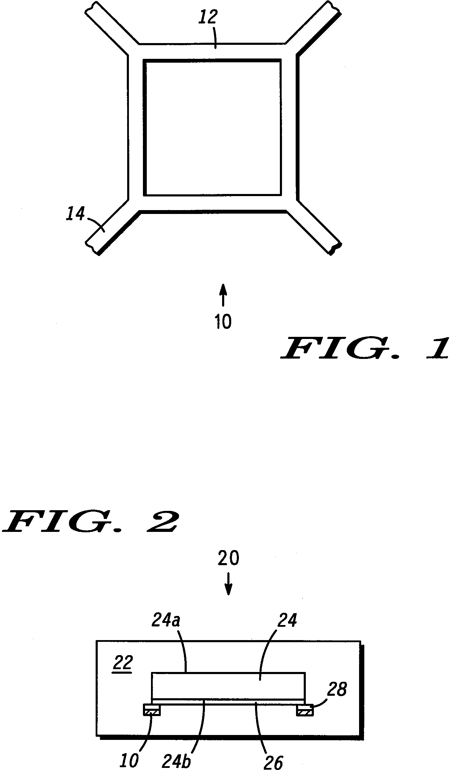

FIG. 1 illustrates a top view of an embodiment of a portion of a leadframe 10 of the present invention. Leadframe 10 is comprised of tie bars 14 and a flag 12 having a central portion removed therefrom. This type of leadframe 10 has been termed "flagless". Advantages of using leadframe 10 are well known in the art and have been disclosed by Lesk et al. in U.S. Patent No. 4,924,291 issued on May 8, 1990, entitled "Flagless Semiconductor Package", which is hereby incorporated herein by reference. Further details of how to fabricate leadframe 10 are found in the reference, as well as different embodiments which may be used.

FIG. 2 illustrates an enlarged, cross-sectional view of an embodiment of the present invention. What is shown is a semiconductor package 20 being comprised of a mold compound 22 encapsulating a semiconductor die 24 which is attached or bonded to flag 12 of leadframe 10. The mold only encapsulates a portion of the leadframe, as is well known in the art. Semiconductor die 24 is attached to leadframe 10 by an epoxy or other polymer 28. Any suitable bonding method may be used. Semiconductor die 24 has a front-side 24a and a back-side 24b. On back-side 24b of semiconductor die 24 a dielectric layer 26 is disposed. Dielectric layer 26 is in physical contact with mold compound 22 and epoxy 28 upon encapsulation. Examples of dielectric layers that may be used are: silicon dioxide, silicon nitride, or oxynitride. Normally, a native oxide grows on back-side 24b. This native oxide, however, is not adequate for providing the advantages obtained by the present invention. When a silicon dioxide layer is used, the thickness of dielectric layer 26 should be of a thickness approximately greater than the thickness of a native oxide. A native oxide has a thickness of approximately less than 10 angstroms. Experiments, have shown that a silicon dioxide thickness of approximately greater than or equal to 200 Angstroms is adequate to prevent popcorn failures. The silicon dioxide of dielectric layer 26 may be either a plasma enhanced chemical vapor deposited oxide, a thermally grown oxide, or any other oxide formed by methods known in the art. However, it may be possible that a thinner dielectric layer 26 may be adequate. Dielectric layer 26 may be formed on semiconductor die 24 having either a polished or ground back-side 24b.

It is the combination of using 'flagless" leadframe 10 and dielectric layer 26 that provides for the advantages of the present invention. In addition, it is desirable that dielectric layer 26 be free from contamination in order to further enhance the adhesion between dielectric layer 26 and mold compound 22.

It has been shown that a "pop-free" semiconductor package which does not delaminate or crack can be fabricated by using a combination of a "flagless" leadframe and a silicon dioxide layer disposed on the backside of a semiconductor die. This combination allows for good adhesion to a mold compound, thus preventing cracking of semiconductor packages during thermal shock.

**Claims**

1.  A semiconducttor package, comprising:
    a leadframe (10) comprised of a flag (12) with a central portion of the flag removed;
    a semiconductor die (24) having a front-side (24a) and a back-side (24b), wherein the back-side (24b) of the semiconductor die (24) is attached to the flag (12);
    a dielectric layer (26) disposed on the back-side (24b) of the semiconductor die (24), wherein the dielectric layer (26) is of a thickness approximately greater than the thickness of a native oxide; and
    a mold compound (22) encapsulating the semiconductor die (24) and a portion of the leadframe (10).

2.  The semiconductor package of claim 1 wherein the dielectric layer (26) is a silicon dioxide layer.

3.  The semiconductor package of claim 2 wherein the silicon dioxide layer is of a thickness of approximately greater than or equal to 200 Angstroms.

4.  The semiconductor package of claim 1, wherein the dielectric layer (26) is a silicon nitride layer.

5.  A semiconductor package, comprising:
    a flagless leadframe (10);
    a semiconductor die (24) having a front-side (24a) and a back-side (24b), wherein the back-side (24b) of the semiconductor die (24) is attached to the flagless leadframe;
    a dielectric layer (26) comprised of silicon dioxide disposed on the back-side (24a) of the semiconductor die (24), wherein the silicon dioxide is of a thickness approximately greater than the thickness of a native oxide; and
    a mold compound (22) encapsulating the semiconductor die (24) and a portion of the flagless leadframe (10).

6.  A semiconductor package, comprising:
    a leadframe (10) comprised of a flag (12) with a central portion of the flag (12) removed;
    a semiconductor die (24) having a front-side (24a) and a back-side (24b), wherein the back-side (24b) of the semiconductor die is attached to the flag;
    a dielectric layer (26) disposed on the back-side (24b) of the semiconductor die (24), wherein the dielectric layer (26) is of a thickness approximately greater than 10 Angstroms; and
    a mold compound (22) encapsulating the semiconductor die (24) and a portion of the leadframe (10).

7.  A method of improving adhesion in a semiconductor package, comprising the steps of:
    providing a semiconductor die (24) having a front-side (24a) and a back-side (24b);
    forming a dielectric layer (26) on the back-side (24b) of the die (24), wherein the thickness of the dielectric layer (26) is approximately greater than the thickness of a native oxide;
    providing a leadframe (10) comprised of a flag (12) with a central portion of the flag removed;
    bonding the back-side (24b) of the semiconductor die (24) to the leadframe (10); and
    encapsulating the semiconductor die (24) and a portion of the leadframe (10) with a mold compound.

8.  The method of claim 7 wherein the step of forming a dielectric layer includes forming a silicon dioxide layer.

9.  The method of claim 8 wherein the step of forming a silicon dioxide layer includes forming a silicon dioxide layer having a thickness approximately greater than or equal to 200 Angstroms.

10. The method of claim 7 wherein the step of forming a dielectric layer includes forming a silicon nitride layer.

*FIG. 1*

*FIG. 2*

**European Patent Office**

## EUROPEAN SEARCH REPORT

Application Number

EP 92 30 3530

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | PATENT ABSTRACTS OF JAPAN<br>vol. 13, no. 571 (E-862)18 December 1989<br>& JP-A-1 238 129 ( NEC CORP ) 22 September 1989 | 1,2,4,<br>6-8,10 | H01L23/495<br>H01L23/31 |
| X | * abstract * | 5 | |
| Y | PATENT ABSTRACTS OF JAPAN<br>vol. 9, no. 263 (E-351)19 October 1985<br>& JP-A-60 109 256 ( OKI DENKI KOGYO KK ) 14 June 1985<br>* abstract * | 1,2,4,<br>6-8,10 | |
| X | PATENT ABSTRACTS OF JAPAN<br>vol. 11, no. 390 (E-567)(2837) 19 December 1987<br>& JP-A-62 154 769 ( HITACHI LTD ) 9 July 1987 | 5 | |
| A | * abstract * | 1,2,6-8 | |
| A | EP-A-0 350 833 (FUJITSU LIMITED)<br>* page 4, line 27 - page 5, line 29; figures 2,3,6 * | 1,5-7 | |

TECHNICAL FIELDS
SEARCHED (Int. Cl.5)

H01L

The present search report has been drawn up for all claims

| Place of search | Date of completion of the search | Examiner |
|---|---|---|
| BERLIN | 18 JUNE 1992 | LE MINH I. |

EPO FORM 1503 03.82 (P0401)